Europäisches Patentamt

European Patent Office

Office européen des brevets

(11) Publication number: **0 666 337 A1**

# EUROPEAN PATENT APPLICATION

(21) Application number: 95100969.5

(22) Date of filing: 25.01.95

(51) Int. Cl.6: **C23C 14/54**, C23C 16/52, G01B 11/06

(30) Priority: 28.01.94 US 187963

(43) Date of publication of application:
09.08.95 Bulletin 95/32

(84) Designated Contracting States:
BE CH DE ES FR GB IE IT LI NL SE

(71) Applicant: **APPLIED MATERIALS INC.**
PO Box 58039
Santa Clara
California 95052 (US)

(72) Inventor: **Nulman, Jaim**
4155-G El Camino Real Way
Palo Alto,
California 94306 (US)
Inventor: **Fishkin, Boris**
4443 Venice Way
San Jose,
California 95129 (US)

(74) Representative: **Kahler, Kurt, Dipl.-Ing. et al**
**Patentanwälte Kahler, Käck, Fiener & Sturm**
**P.O. Box 12 49**
**D-87712 Mindelheim (DE)**

(54) Method and apparatus for measuring the deposition rate of opaque films.

(57) A film deposition monitor is described in which a beam of light (20) is reflected from the surface of a substrate (10) undergoing deposition. By monitoring the position of the reflected beam (22), either the film deposition rate or the total thickness of the film deposited can be determined in situ. Before any film is deposited on the surface of the deposition substrate (10), the beam of reflected light (22) strikes an optical detector (18) at a first position. After some thickness of a film has been deposited on the surface of the substrate (10), the beam of light is reflected from a position on the surface of the newly deposited film. The position from which the beam reflects is displaced both in height above the substrate (10) and along the plane of the substrate (10) with respect to the original reflection position. Light (22) reflected from the surface of the newly deposited film strikes the optical detector (18) at a position displaced from where the original (no film) reflected beam struck the optical detector (18). A film deposition monitor in accordance with the present invention can be used as an *in situ* process monitoring tool.

Fig. 2

### Field of the Invention.

The present invention relates to the deposition of films and, more particularly, to monitoring the deposition of films.

### Background of the Invention.

The diminished size of structures in modern semiconductor devices places extreme demands on semiconductor processing equipment. One answer to these demands is to improve process monitoring and to implement improved process control based on the process monitoring. *In situ* process monitoring allows the progression of process steps to be monitored to ensure that process variables such as input power, gas pressure, source age, and others are properly compensated to ensure consistent processing results. Increasing the level of process monitoring also reduces costs. Because of the complexity of semiconductor devices and the number of devices formed on each wafer, each wafer start represents a substantial investment. It is therefore often desirable to monitor the progress of critical wafer processing steps to ensure that the steps are properly completed.

One of the important process steps in semiconductor device processing, as well as in other types of device processing, is the deposition of metal films. Deposited metal films are formed into interconnect lines, bus structures, Schottky barriers, ohmic contacts or other device structures. Deposition of an appropriate thickness of metal film is generally important to the performance of the interconnect lines or other devices formed from the metallic layers. If too thin a metal film is deposited, an interconnect line formed from that film may be unacceptably resistive or may have a greater likelihood of becoming an open circuit either during subsequent processing steps or during the normal operation of the device. The deposition of unnecessarily thick metal films is also undesirable because the film deposition takes longer than is necessary and the film thickness may be in excess of the tolerances of later processing steps. Accordingly, it is desirable to maintain metal film thicknesses near their optimal levels. Because the variation of some process variables cannot be accurately predicted over the course of many process runs, it is desirable to utilize an *in situ* process monitoring system.

One type of thickness monitor that has been used to monitor semiconductor processing steps is a thickness monitor based on a quartz oscillator. In such thickness monitors, a quartz oscillator is placed adjacent to the substrate that is being coated with deposition material. As metal is deposited on the substrate, metal is also deposited on the quartz oscillator. Metal accumulating on the quartz oscillator changes the mass of the oscillator and, consequently, the resonant frequency of the oscillator. By electrically detecting the variation in the resonant frequency of the oscillator, the total amount of metal deposited on the exposed surface of the oscillator can be calculated. Quartz oscillators often fail, resulting in a lack of process information during that process run and requiring that the thickness monitor be replaced, resulting in unacceptable down time for the semiconductor processing equipment. Moreover, even if a quartz oscillator functions reliably, it becomes increasingly less sensitive with continued usage and eventually fails to function as a thickness monitor. Finally, quartz oscillators typically do not sample the thickness of metal deposited on the deposition substrate; instead, such oscillators sample the deposition of metal adjacent to the substrate.

### Summary of the Invention.

The invention is defined by claims 1, 10 and 19, respectively. Particular embodiments of the invention are set out in the dependent claims.

In accordance with one aspect of the present invention, a film deposition monitoring system includes a collimated light source that directs a beam of light toward a deposition substrate. The beam of light is reflected from the deposition substrate toward an optical detector disposed to receive the reflected beam of light. The optical detector detects the position at which the reflected beam of light is incident on the optical detector.

In accordance with another aspect of the present invention, a film deposition monitoring system may be used in a physical vapor deposition system. A light source directs an incident beam of light toward a semiconductor wafer, and a beam of light is reflected from the substrate. An optical detector capable of detecting the position at which the reflected beam of light is incident on the optical detector is disposed at a position to receive the reflected beam of light.

In accordance with a further aspect of the present invention, a thickness monitoring system is coupled to a control system and is used to adjust processing parameters over the life of a deposition source.

### Brief Description of the Drawings.

Fig. 1 illustrates deposition rates achieved at given input power for an aging sputter deposition target.

Fig. 2 shows a film deposition monitor in accordance with a preferred embodiment of the present invention.

Figs. 3 & 4 schematically illustrate a measurement technique in accordance with the present invention.

Fig. 5 illustrates another embodiment of a film deposition monitor in accordance with the present invention.

**Detailed Description of the Preferred Embodiments**.

The present invention relates to a reflective film deposition monitoring system. In preferred embodiments of the present invention, a film deposition monitor is used to measure thickness or the rate of deposition of films in processing equipment such as that typically used for semiconductor processing. By reflecting a beam of light from the surface of the substrate undergoing deposition and by monitoring the position of the reflected beam, either the film deposition rate or the total thickness of the material deposited can be determined *in situ*. Before any film is deposited on the surface of the deposition substrate, the beam of reflected light strikes an optical detector at a first position. After some thickness of a film has been deposited on the surface of the substrate, the beam of light is reflected from a position on the surface of the newly deposited film. The position from which the beam reflects is displaced both in height above the substrate and along the plane of the substrate away from the original (no film) reflection position. The beam of light reflected from the surface of the newly deposited film strikes the optical detector at a position displaced from where the original (no film) reflected beam struck the optical detector. Either the film thickness or the film deposition rate can be determined from the displacement of the reflected beam along the surface of the optical detector. A film deposition monitor in accordance with the present invention can be used as an *in situ* process monitoring tool.

Metal films can be deposited, for example, by chemical vapor deposition (CVD) or by physical vapor deposition (PVD). PVD is a general term which includes both evaporation and sputtering techniques. In the sputter deposition of metal films, a target comprising the metal to be deposited is disposed above the substrate on which the metal film is to be deposited. The sputtering target is typically coupled to either a DC or radio frequency (RF) power supply capable of applying a negative voltage to the target. Generally, a gas in which a glow discharge can be maintained is introduced into the region between the target and the deposition substrate. Often, argon is used as the glow discharge medium. A glow discharge is established in the region between the sputtering target and the deposition substrate. Positive ions from the glow discharge region accelerate into the target, striking the target with sufficient momentum to cause metal molecules or atoms to be ejected from the surface of the target. Metal atoms from the target condense on the deposition substrate, forming a film of metal on the surface of the deposition substrate.

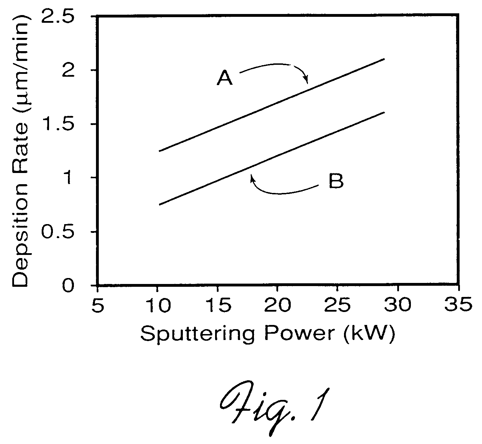

Targets used for the sputter deposition of thin films experience an aging effect. For example, the deposition rate that can be obtained at a given input power level has been observed to decrease with increasing target age. Fig. 1 illustrates this phenomenon. Fig. 1 shows the dependence of the deposition rate on the level of power input to the sputtering source at different times in the lifetime of the target. Curve A shows the deposition rate achieved at varying power levels for a new target; curve B illustrates the deposition rates achieved for a target near the end of its life. Two important points emerge from Fig. 1. First, critical processing characteristics, such as the deposition rate, may vary from run to run for a given piece of processing equipment in ways that can affect the yield and quality of devices processed in that processing equipment. Second, by measuring processing characteristics *in situ* within the deposition system and by adjusting processing variables, such as the power input to the sputtering source, in response to the observed variations in processing characteristics, the processing characteristics of the deposition system can more readily be maintained near desired levels.

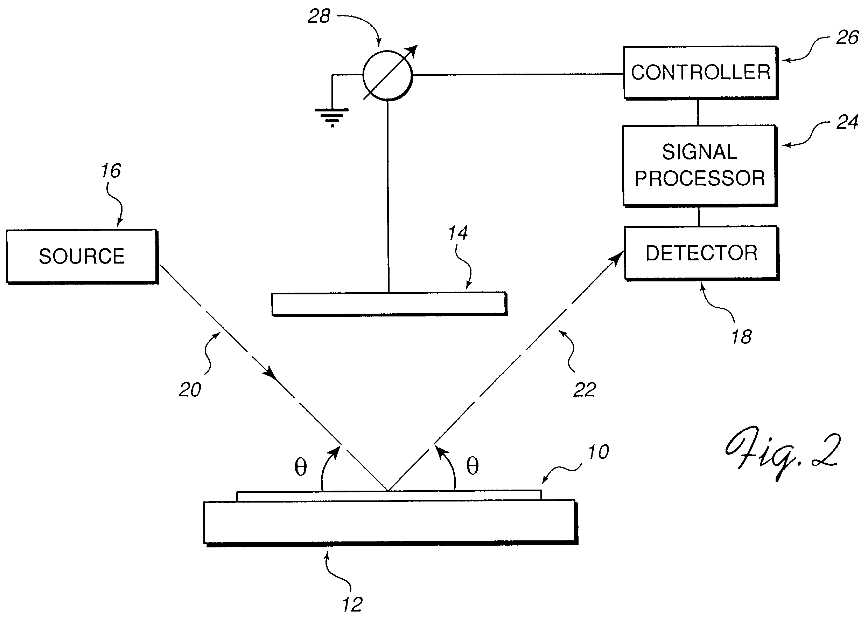

To this end, preferred embodiments of the present invention may be used to monitor the deposition of films within processing equipment. For example, preferred embodiments of the present invention may be used to measure either the thickness or the rate of deposition of metal film layers deposited on the surface of a semiconductor device during the deposition of the metal films. One preferred embodiment is shown in Fig. 2. Fig. 2 illustrates an exemplary processing environment and, in particular, is a schematic illustration of a physical vapor deposition system. A deposition substrate 10 is disposed on a support 12 and is preferably placed parallel to a thin film deposition source 14. Deposition occurs by the transfer of material from the deposition source 14 to the surface of the deposition substrate 10. Power is input to the deposition source 14 from a power supply 28 that is preferably controlled by controller 26. An example of a sputter deposition system is the Endura 5500 available from Applied Materials, Inc., of Santa Clara, California. Wang describes a sputter deposition system in U.S. Patent No. 5,108,570.

A beam of light 20 projected from a light source 16 is incident onto the surface of deposition substrate 10. The beam of light 20 reflects from the surface of the deposition substrate 10 toward a linear optical detector array 18 disposed at an appropriate position with respect to the reflected beam of light. Presuming simple first surface reflection from the surface of the deposition substrate 10, light incident on the surface of the deposition substrate 10 at an angle $\theta$ with respect to the surface of the deposition substrate 10 is reflected at a complementary angle $\theta$ with respect to the surface. Linear optical detector array 18 is disposed so that the reflected beam of light 22 is incident on detector array 18. As material from the deposition source 14 accumulates on the surface of substrate 10, the beam of light 20 reflects from the newly deposited material rather than from the surface of the deposition substrate 10. This will be particularly true for metal films, which can be effective reflectors of visible light even for very thin films. Because the beam of light 20 is reflected from the surface of the newly deposited material, the reflected light 22 strikes the linear optical detector array 18 at a position displaced away from the position struck by the beam of light reflected from the original surface of the substrate. By monitoring the position at which the reflected beam 22 is incident on the linear optical detector array 18, the thickness of the film deposited on the surface of the deposition substrate can be determined. By monitoring the rate of change in the position of the reflected beam, the rate of deposition can be determined.

One possible application of the present system is to monitor the variation of the deposition rate caused by the aging of the sputtering target in a sputter deposition system. The effect of target aging on deposition rate in such a system is illustrated in Fig. 1, discussed above. In a sputtering system which exhibits target aging effects, a decrease in target efficiency will be mirrored by a similar decrease in the rate of thin film deposition at a given input power level. This decrease in the target's efficiency can be accurately tracked by monitoring the relative or proportional decrease in the rate of thin film deposition over the life of the sputtering target. In preferred embodiments of the present invention, signal processor 24 may store information related to the thin film deposition rate for a typical new deposition target, or it may store the operational history of a particular deposition target. Later deposition rate measurements can be compared with earlier "baseline" data within signal processor 24. In particularly preferred embodiments of the present invention, data from the signal processor 24 can be supplied to the controller 26 to form a closed-loop control system. Thus, the power input from power supply 28 to target 14 can be varied to compensate for target aging.

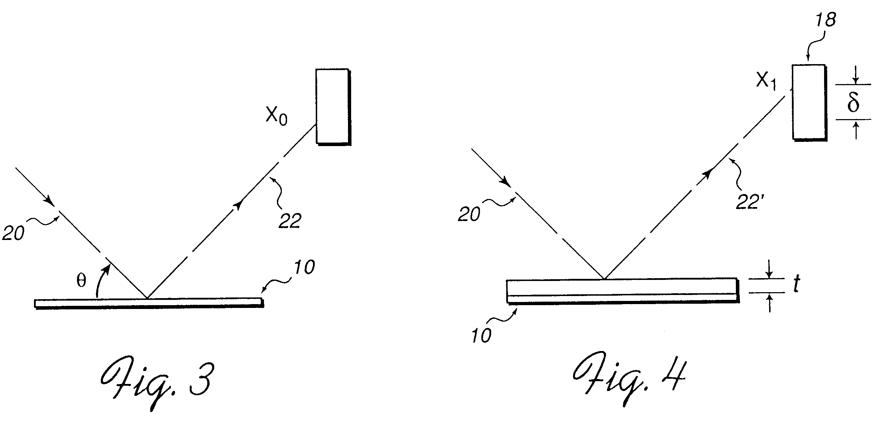

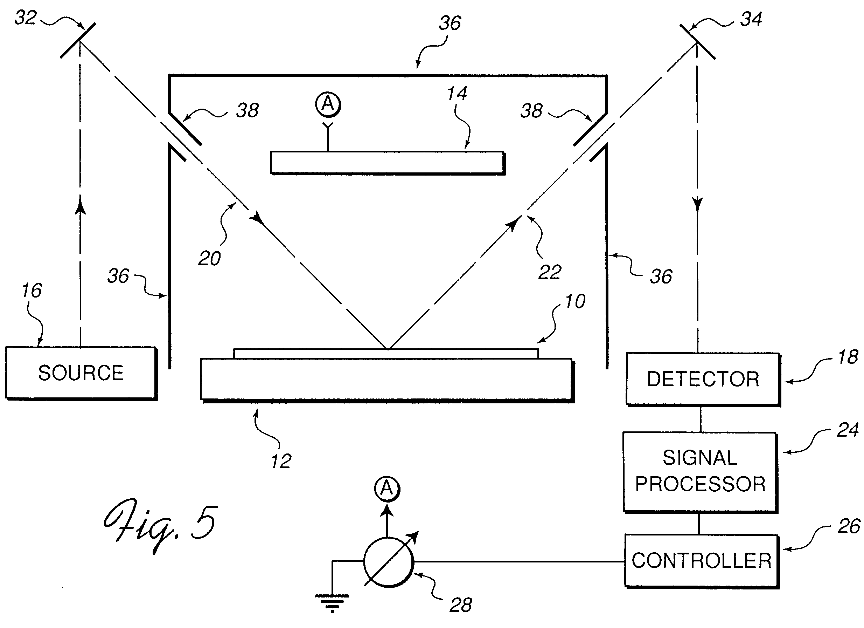

Figs. 3 & 4 present a further illustration of the preferred embodiment of Fig. 2. To facilitate the understanding of the present invention, in these and other figures discussed herein the same reference numerals are used to indicate the same or similar structures. Before the deposition of any material on deposition substrate 10, a beam of light 20 is incident at an angle $\theta$ with respect to the surface of the substrate 10. A beam of light 22 reflects from the surface of the substrate 10 at a complementary angle $\theta$ with respect to the surface of the substrate 10 and is incident on linear detector array 18 at a first detector position $x_0$. Fig. 4 illustrates the reflection geometry after a film of thickness $t$ has been deposited on the substrate 10. The beam of light 20 incident on the surface of the substrate is reflected as beam 22' from the surface of the deposited film to a new position $x_1$ on the detector array 18. Not only is the beam 22' reflected from a position displaced in height above the substrate 10, the new reflection position is displaced horizontally, *i.e.*, along the surface of the substrate. Thus, the distance $\delta$ by which the position of the reflected beam is shifted can be greater than the thickness $t$ of the film deposited, depending on the angle at which the linear detector array is disposed. For the particular geometry illustrated in Figs. 3 & 4 , the displacement $\delta$ of the reflected beam from position $x_0$ to $x_1$ will be given by

$$\delta = 2 \cdot t.$$

The rate of thin film deposition for this geometry will thus be one half of the rate of change of the displacement $\delta$.

Of course, other geometries will have different displacement and rate of deposition relationships, and it will generally be simplest to calibrate the film deposition monitor of the present invention as installed within a given piece of processing equipment. For the particular geometry illustrated in Fig. 2 and Figs. 3 & 4 , the magnitude of the displacement change $\delta$ at the surface of the linear optical detector array 18 is insensitive to variations in the value of $\theta$. In practice, the geometries preferred for a film deposition monitor in accordance with the present invention will be primarily determined by space that is available within the chamber in which the measurement is being performed.

The exact position of the surface of the deposition substrate 10 will not be known with precision prior to the placement of the substrate 10 on the support 12. While the position of the surface is typically not needed for a deposition rate measurement, it is preferred for some methods of determining total film thickness. In such cases, it is preferable to detect the position $x_0$ at which the reflected beam 22 strikes the optical detector array 18 before the deposition of any film on the substrate 10. A film deposition monitor can be used to indicate the stopping point of a processing step by monitoring the detector array 18 to determine when the reflected be position $x_1$ (at which the reflected beam 22' strikes the optical detector array 18) reaches a predetermined position and stopping the processing step accordingly by turning off a variable power source 28 (shown in Fig. 2) used to energize the deposition source 14. In other embodiments of the present invention, the film deposition monitor can be used to monitor the deposition rate achieved in the processing system. As such, the film deposition monitor of the present invention can be used as part of a closed loop control system to maintain the deposition rate within certain predetermined bounds. For example, in a sputtering system such as that described by the graphs of Fig. 1, the deposition rate can be adjusted by adjusting the power input to the sputtering source.

To allow greater thickness sensitivity, it is desirable to use a highly collimated beam of light having a small beam size for the light source 16. Thus, it is generally desirable to use a laser as the light source for the present invention. In practice, semiconductor lasers are very useful for the present invention because of their low cost, easy availability, the small size of the lasers and the ready availability of well-matched optical detectors. If there is an optical noise source within the deposition environment, such as a glow discharge plasma or other high temperature black body, it is desirable to select a laser wavelength that is easily distinguished from the optical noise source. Alternately, a filter that is transmissive only at the wavelength of the laser light may be placed in front of the optical detector array 18. In another alternate embodiment, the laser signal may be electrically or mechanically chopped, and signal detection can be synchronized at the chopping frequency. As is generally the case with semiconductor lasers, it is typically desirable to maintain the laser at or near its optimum operating temperature in the course of operation. This is typically not difficult to achieve either by cooling the laser or by disposing the laser remote from the primary heat sources within the processing environment. Alternatively, a fiber optic device can be used to couple light from a semiconductor or other laser into the processing environment. Optical fibers are well suited for this purpose because optical fibers can readily be fitted into the high vacuum environments that are typically used in deposition systems. Whether a laser or an optical fiber is used, it is sometimes preferred to employ beam shaping optics or to spatially filter the input beam of light if a particularly high level of sensitivity is desired. In practice, the sophistication required of the optical system will depend on the sensitivity required of the system.

It is generally desirable to use an optical detector array 18 that is wavelength compatible with the light source 16. Because relatively high resolution is demanded of this system, a charge coupled device (CCD) detector is used in preferred embodiments of the present invention. Alternatively, a linear array of miniature optical detectors may be used. To aid in the signal detection, it is preferable to mechanically or electrically chop the light source 16 and to synchronize the optical detector with the chopper. Chopping may not be necessary in systems where there is little optical noise in the deposition environment.

The deposition substrate 10 may be, for example, a silicon wafer undergoing integrated circuit device processing, or the substrate might be a glass substrate for use in liquid crystal displays. Support 12 may be an electrostatic chuck, vacuum chuck, or other of the support devices well known in the art of processing equipment. For example, support 12 may be a plate that is adapted for use with a clamping ring. Deposition source 14 may be an evaporation source or a sputtering target. The film deposition monitor of the present invention is generally more easily implemented in physical vapor deposition systems because there is relatively little difficulty in ensuring that optical surfaces are adequately protected in the processing environment. However, it is possible to use a film deposition monitor in accordance with the present invention in a chemical vapor deposition system, although it may be undesirable if photochemical reactions take place at the deposition surface. In a chemical vapor deposition system, the deposition source 14 may be a "shower head" source of ions, or it may be the anode of a glow discharge (CVD) system.

The present system is most easily implemented to monitor the deposition of metal films. This is because thin metal films readily reflect optical radiation. While embodiments of the present invention are most readily employed to monitor the deposition of metal films or other reflective films, it is also possible to monitor the deposition of semiconductor and dielectric films. One may choose, for example, to use a light source having a wavelength that is strongly absorbed by the material being deposited so that only first surface reflections are observed at detector array 18. Alternately, in films where both first surface and back surface reflection occurs, the thickness of the film can be measured by measuring the increase in the apparent beam width that occurs because of the multiple reflections. In practice, the beam widening can be empirically correlated with the thickness of the film.

In a particularly preferred embodiment of the present invention, a film deposition monitor can be used as a process monitor for the deposition of thin metal films by physical vapor deposition. For example, the film deposition monitor may be used in a sputtering system for the deposition of metal films. One such system is illustrated in Fig. 5. Metal atoms or molecules are ejected from the target 14 and are deposited on the surface of the substrate 10, which may be, for example, a silicon wafer on which integrated circuits are being formed. Light source 16 directs a beam of light off of a first mirror 32, or off of an assembly of mirrors, toward the substrate 10. Reflected beam 22 is incident on a second mirror 34, or on an assembly of mirrors, before it is incident on the detector 34. A shield 36 may be disposed so as to encompass the sputtering region, as generally indicated in the figure. Optical ports 38 extend from the walls of the shield 36 to block the passage of sputtered material and to shield optical surfaces exterior to the shield 36 from line of sight exposure to the sputtering target 14. Both light source 16 and linear optical detector array 18 are, in this embodiment, remotely disposed from the sputtering environment. In this way, the operating temperatures of these components may be optimized and the optical surfaces of the light source 16, including any beam shaping optics, and of the detector array 18, can be removed from line of sight exposure to the sputtering target 14. Physical vapor deposition sources deposit material primarily along a line of sight path from the source. Accordingly, if optical surfaces are not exposed to line of sight exposure from the sputtering target 14, no sputtered material is deposited on the light source 16 and detector 18.

A film deposition monitor in accordance with the present invention can be used for process control in a physical vapor deposition system such as that illustrated by Fig. 5. For example, the deposition rate associated with deposition under a particular set of processing conditions may be compared against a value of deposition rate corresponding to a new deposition target within the signal processor 24. The variations in the deposition rate over the life of a deposition target can then be compensated for within controller 26 by, for example, increasing the level of DC power input from power supply 28 to the deposition target. By monitoring the deposition rate on a periodic basis, thin film deposition characteristics can be maintained near a constant level over the life of a deposition target. Typically, the deposition rate monitor will be coupled to or integrated with the control systems within the physical vapor deposition system. Process variables other than target aging may similarly be monitored and compensated for if they affect the thin film deposition rate.

While the present invention has been described with reference to specific preferred embodiments thereof, it will be understood by those skilled in this art that various changes may be made without departing from the true spirit and scope of the invention. In addition, many modifications may be made to adapt the invention to a given situation without departing from its essential teachings.

**Claims**

1. A film deposition monitoring system comprising:

    a fixture (12) adapted to support a deposition substrate (10);

    a light source (16) that directs a beam of light (20) toward said fixture (12);

    an optical detector (18) positioned so as to receive a beam of light (22) reflected from a deposition substrate (10) supported by said fixture (12), said optical detector (18) being capable of detecting the position at which said reflected beam of light (22) is incident on said optical detector (18); and

    means (24) for detecting a change in the position at which said reflected beam of light (22) is incident on said optical detector (18).

2. A film deposition monitoring system in accordance with claim 1, further comprising a semiconductor wafer as a deposition substrate (10).

3. A film deposition monitoring system in accordance with claim 1 or 2, wherein said light source (16) comprises a semiconductor laser.

4. A film deposition monitoring system in accordance with any of claims 1 to 3, wherein said optical detector (18) is a charge coupled device or a linear semiconductor array.

5. A film deposition monitoring system in accordance with any of claims 1 to 4, further comprising a closed loop control system (26) that adjusts deposition parameters in response to a signal generated by said optical detector (18).

6. A film deposition monitoring system in accordance with any of claims 1 to 5, further comprising means (24) for detecting a rate of change in the position at which said reflected beam of light (22) is incident on said optical detector (18).

7. A film deposition monitoring system in accordance with claim 6,
further comprising a control system (26) that adjusts deposition parameters in response to said rate of change in the position at which said reflected beam of light (22) is incident on said optical detector (18).

8. A substrate deposition system comprising:
a fixture (12) adapted to support a deposition substrate (10);
a deposition source (14) disposed adjacent to said fixture (12);
a light source (16) that directs a beam of light (20) toward said fixture (12); and
an optical detector (18) positioned so as to receive a beam of light (22) reflected from a deposition substrate (10) supported by said fixture (12), said optical detector (18) being capable of detecting the position at which said reflected beam of light (22) is incident on said optical detector (18).

9. A substrate deposition system according to claim 8,
wherein said deposition source (14) is a sputtering target.

10. A substrate deposition system according to claim 8 or 9,
further comprising a shield (36) disposed around said fixture (12) and said deposition source (14), said shield (36) having a plurality of ports (38) for the passage of light.

11. A substrate deposition system according to claim 10, further comprising:
a first mirror (32) disposed so as to direct said beam of light (20) toward said fixture (12); and
a second mirror (34) disposed so as to direct said reflected beam of light (22) toward said optical detector (18).

12. A substrate deposition system according to any of claims 8 to 11,
further comprising a closed loop control system (26) that adjusts deposition parameters in response to a signal generated by said optical detector (18).

13. A substrate deposition system according to claim 12,
further comprising a power supply (28) coupled to said deposition source (14), wherein said power supply (28) is coupled to and is at least partially controlled by said closed loop control system (26).

14. A substrate deposition system according to claim 12,
wherein said signal generated by said optical detector (18) represents a time rate of change of an output signal from said optical detector (18).

15. A substrate deposition system according to any of claims 8 to 14,
wherein said optical detector (18) comprises an array of optical sensors.

16. A substrate deposition system according to claim 15,
wherein said array of optical sensors is a charge coupled device.

17. A method of depositing films comprising the steps of:
directing an incident beam of light (20) generated by a light source (16) toward a deposition substrate (10);
depositing a film on a surface of said deposition substrate (10);
reflecting said incident beam of light from said film deposited on said surface of said deposition substrate (10) to form a reflected beam of light (22) directed toward an optical detector (18);
detecting where said reflected beam of light (22) strikes said optical detector (18); and
adjusting the deposition rate in response to a signal generated by said optical detector (18).

18. The method of claim 17,
wherein said directing, reflecting and detecting steps operate during said depositing step.

19. The method of claim 17 or 18,
further comprising the steps of:
passing said incident beam of light (20) through a first optical port (38) in a shield (36) disposed around said deposition substrate (10);
passing said reflected beam of light (22) through a second optical port (38) in a shield (36) disposed around said deposition substrate (10).

20. The method of any of claims 17 to 19,
further comprising the step of calculating the time rate of change of a signal output by said optical detector (18).

21. The method of claim 20,
further comprising the steps of:
comparing said time rate of change of a signal output by said optical detector (18) to a baseline deposition rate value to develop a measure of target efficiency; and

adjusting an input power level in response to said measure of target efficiency.

22. The method of claim 21,
wherein said input power level comprises the power input to a sputtering target (14).

*Fig. 1*

*Fig. 2*

EP 0 666 337 A1

$\textit{Fig. 3}$

$\textit{Fig. 4}$

Fig. 5

EP 0 666 337 A1

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | PATENT ABSTRACTS OF JAPAN vol. 013 no. 125 (P-847) ,28 March 1989 & JP-A-63 295907 (MITSUBISHI ELECTRIC CORP) 2 December 1988, | 1,2,8,9, 15 | C23C14/54 C23C16/52 G01B11/06 |
| Y | * abstract * | 3,5-7, 10,12, 13,17-19 | |
| X | PATENT ABSTRACTS OF JAPAN vol. 014 no. 349 (P-1084) ,27 July 1990 & JP-A-02 124406 (MITSUBISHI ELECTRIC CORP) 11 May 1990, * abstract * | 1,8 | |
| Y | PATENT ABSTRACTS OF JAPAN vol. 011 no. 249 (E-532) ,13 August 1987 & JP-A-62 062513 (FUJITSU LTD) 19 March 1987, * abstract * | 5-7,10, 12,13, 17-19 | |
| Y | PATENT ABSTRACTS OF JAPAN vol. 014 no. 128 (P-1019) ,9 March 1990 & JP-A-01 320408 (NIPPON STEEL CORP) 26 December 1989, * abstract * | 3 | **TECHNICAL FIELDS SEARCHED** (Int.Cl.6) C23C |

The present search report has been drawn up for all claims

| Place of search | Date of completion of the search | Examiner |
|---|---|---|
| THE HAGUE | 19 May 1995 | Ekhult, H |

EPO FORM 1503 03.82 (P04C01)